# EUROPEAN PATENT APPLICATION

(11) **EP 1 101 555 A2**
(43) Date of publication of application: **23.05.2001**
(21) Application number: 00121479.0
(22) Date of filing: 29.09.2000
(51) Int. Cl.: B23B 39/16, B27C 3/04, H05K 3/00

(54) **Spindle drilling head for machine tools for machining panels**

(30) Priority: 30.09.1999 IT BO990529
(71) Applicant: H.S.D. S.r.l., 61100 Pesaro (IT)
(72) Inventor: Selci, Giancarlo, 61100 Pesaro (IT)
(74) Representative: Jorio, Paolo

(57) **Abstract**

A spindle drilling head (1) for machine tools (4) for machining panels (2); the head (1) being characterized by having at least a first (11) and at least a second (12) drilling device superimposed one over the other, each drilling device (11, 12) having a respective number of actuators (19) associated with a respective number of spindles (14); and in that the spindles (14) in the first number of spindles (14) of the first drilling device (11) are offset with respect to the spindles (14) in the second number of spindles (14) of the second drilling device (12), so that, in general, each axis (16) of each spindle (14) of the first drilling device (11) is located between two adjacent actuators (19) of the second drilling device (12).

## Description

The present invention relates to a spindle drilling head for machine tools for machining panels of wood, plastic or similarly hard materials, and which may be used for manufacturing furniture.

Panels of wood, plastic or similarly hard materials are known to be machined on drilling/milling machines having at least one drilling head comprising a number of side by side spindles, each for holding a tool such as a twist drill or cutter. The respective longitudinal axes of the spindles are parallel and spaced a small distance apart to machine parallel holes with a small center distance, which, due to current standardization in the furniture industry, is normally fixed and generally 32 mm in Europe and 30 mm in other countries such as Japan, to enable the machining, for example, of shelf supporting pin seats in vertical members.

As is known, there are drilling heads with fixed spindles, which rotate and are axially fixed, and drilling heads with independent spindles, which not only rotate but are also axially, in particular vertically, movable individually. As regards spindle rotation, both types of heads employ the same type of transmission, as explained below.

In a first known embodiment of a fixed-spindle drilling head, the drilling head comprises a box body housing rotary, axially fixed spindles; and a rotation transmission cooperating with and mechanically connecting the spindles to a single actuator fitted to the box body. Drilling heads of this type therefore have a single rotation transmission device - normally a chain, gear, or toothed belt transmission - for rotating all the spindles. With any of the above mechanical transmissions, however, special precautions must be taken to keep the drilling head in good working order. For which reason, the drilling head must be equipped with cooling systems for cooling the inside of the box body, which is done using a lubricating substance in the case of a gear or wheel and chain transmission, and by means of a forced air cooling fan in the case of a belt transmission.

As will be clear from the foregoing description, the actuator therefore operates all the spindles, even those with no tools. The impossibility of selecting the spindles actually involved in the machining operation means each spindle is activated for a total work time normally in excess of actual machining time, so that wear of the rotary components (e.g. the gear, chain or belt wheel teeth) is greater than it would be in terms of actual machining time.

Moreover, to enable each spindle to cut the panel material in higher than normal power consumption conditions, all the other spindles must also be powered accordingly, so that the power required to operate the head is normally greater than that strictly necessary to do the actual work, thus resulting in considerable energy waste. Moreover, continual microcollision of the toothed components transmitting the torque required to rotate the spindles results in noise, which is directly proportional to the number of spindles activated. That is, operating more than the required number of spindles obviously produces a higher noise level than would be produced by only operating the number of spindles strictly required to perform the machining cycle. Moreover, in the case of a gear transmission, one spindle rotates clockwise and the next anticlockwise, so that right- and left-hand tools must be used, and care taken to ensure each is assembled correctly. Moreover, the drilling head itself is of complex design on account of the large number of spindles involved and the location of the spindles with respect to the one actuator. What is more, the drilling head can only support at most 40 spindles.

In short, drilling heads of the above first known embodiment generally have the following drawbacks: severe wear of moving parts; compulsory lubrication or air cooling of the box body housing the spindles; high noise level; considerable energy waste; no selective spindle operation; complex construction; possible misassembly of right- and left-hand tools; maximum 40-spindle capacity; complex head assembly/disassembly procedure; time-consuming head servicing/repair procedure; and the need for specially designed heads to specific user specifications.

To eliminate the above drawbacks, a second known embodiment has been proposed in which a machining head comprises a number of spindles, each housed to rotate freely inside a box body supporting an actuating member for rotating each spindle.

Though a considerable improvement with respect to heads in the first embodiment, this solution, to achieve said 32 mm center distance (30 mm in Japan), has the disadvantage of requiring excessive miniaturization of the electric motors for rotating the drilling/milling tools.

Small electric motors, in fact, have been found to result in low static torque values, a fairly short working life of the electric windings, and a reduction in the maximum power of the motor.

It is therefore an object of the present invention to provide a spindle drilling head for machines for machining materials such as wood, plastic and similar, designed to eliminate the aforementioned drawbacks, and which may feature fixed spindles, or independent spindles movable in a direction parallel to the axis of symmetry of the drilling/milling tools.

According to the present invention, there is provided a spindle drilling head for machine tools for machining panels of wood, plastic or other materials of similar hardness; the head comprising a number of side by side spindles, each having a respective longitudinal axis of rotation; each spindle supporting a respective tool; an actuator, cooperating with each spindle, being provided to rotate the respective spindle; each actuator being connected mechanically to only one of the spindles; and the head being characterized by comprising at least a first and at least a second drilling device superimposed one over the other, each drilling device comprising a respective number of actuators associated with a respective number of spindles; and in that the spindles in the first number of spindles of the first drilling device are offset with respect to the spindles in the second number of spindles of the second drilling device, so that, in general, each axis of each spindle of the first drilling device is located between two adjacent actuators of the second drilling device.

The main advantage of the present invention lies in providing a head which, while having an actuator for each spindle with a standard center distance between two successive drilling/milling tools, features electric motors of considerable size, when compared with those of said known second embodiment. In fact, the electric motors are substantially twice the size of those in the second embodiment, thus enabling more power, higher static torques and a longer working life in general. Reducing wear also reduces the frequency with which the electric motors need replacing, thus greatly reducing the maintenance cost of the head.

As stated, the above advantages are achieved by providing a spindle drilling head having two similar superimposed drilling devices offset with respect to each other, so that each tool of the top drilling device is located between two adjacent electric motors of the bottom drilling device.

A number of non-limiting embodiments of the invention will be described by way of example with reference to the accompanying drawings, in which:
Figure 1 shows a schematic view in perspective of a machine tool featuring a first preferred embodiment of a spindle drilling head in accordance with the teachings of the present invention;
Figure 2 shows a side view of the Figure 1 spindle drilling head;
Figure 3 shows a cross section of a second preferred embodiment of an actuator fitted to the head in accordance with the teachings of the present invention;
Figure 4 shows a plan view of a variation of a detail of the drilling head according to the present invention.

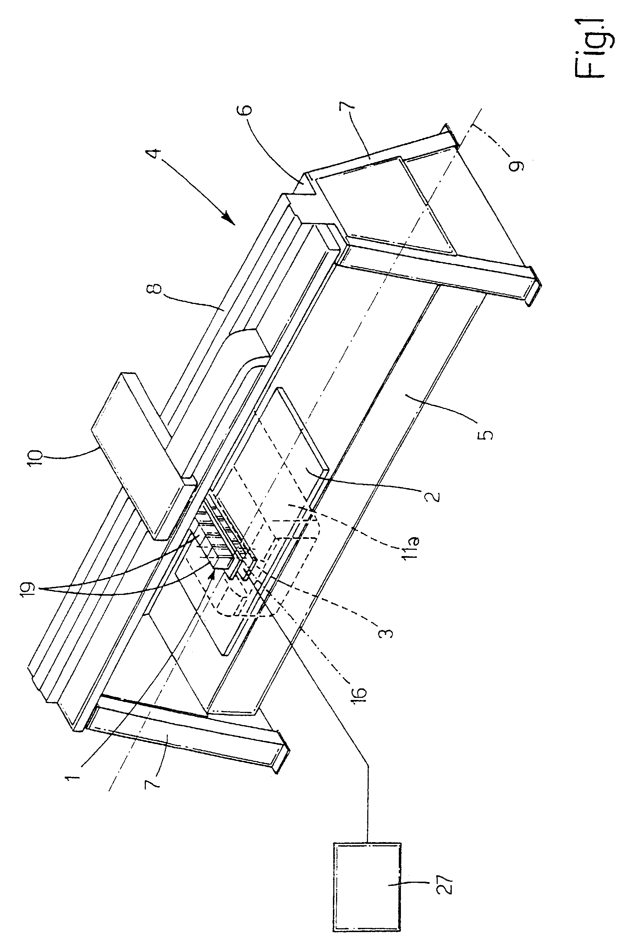

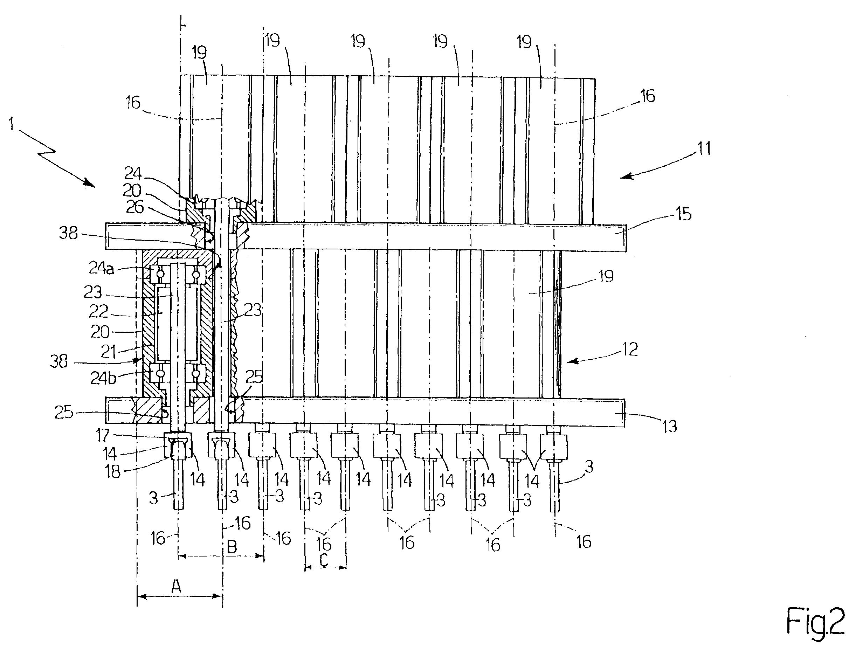

Number 1 in Figures 1 and 2 indicates as a whole a spindle drilling head which may be used for machining panels 2 of wood, plastic or other materials of similar hardness by means of substantially cylindrical tools 3, e.g. twist drills or cutters. In the Figure 2 example, spindle head 1 is an independent-spindle type.

Head 1 can be fitted to a machine tool 4 (shown only in Figure 1) having a bed 5 for supporting and clamping panels 2 when drilling and/or milling panels 2 clamped to machine 4. Machine 4 also comprises, over bed 5, a fixed gantry frame 6 having two uprights 7 supporting a longitudinal member 8 extending in a direction 9 and longitudinal with respect to bed 5. Machine 4 supports head 1 by means of an actuating device 10 (known and therefore shown only schematically) for moving head 1 in three perpendicular directions, including direction 9, a vertical direction, and a direction perpendicular to the other two (x, y, z axes). Actuating device 10 is provided with a substantially parallelepiped-shaped guard 11 for preventing the chips produced by tools 3 from being projected outwards of head 1.

With reference to Figure 2, drilling head 1 comprises, innovatively, at least two superimposed devices 11, 12 supported by a plate 13.

Each device 11, 12 in turn comprises a number of side by side, substantially equally spaced spindles 14. Devices 11 and 12 may be separated by a further plate 15 parallel to plate 13; and plates 13 and 15 may be straight, as in Figure 2, or of any other shape, e.g. L-, T-, U-shaped, depending on the user's requirements, without this complicating the design of head 1, and may be of any size, both in terms of shape and length.

In a variation not shown, plate 15 is dispensed with, and the actuators 19 of first drilling device 11 simply rest on the actuators 19 of second drilling device 12.

In a further variation not shown, at least one of plates 13, 15 is connected stably to a box structure (not shown) fully enclosing all the actuators 19 of first drilling device 11 and second drilling device 12.

Each spindle 14 of device 11 or device 12 has a longitudinal axis of rotation 16, which, in the Figure 2 embodiment, is vertical; each spindle 14 has a seat 17 for integrally housing a shank 18 of respective tool 3; and the top face of each of plates 13, 15 supports a number of rotary actuators 19, each of which is coaxial with a respective spindle 14.

Each actuator 19 is defined by an electric motor, which is a brushless type in one embodiment, a direct-current motor in a further embodiment, and an asynchronous electric motor in yet a further embodiment. As will be obvious to a person skilled in the art, spindle drilling head 1 according to the present invention may therefore employ any type of electric motor.

Again with reference to Figure 2, each actuator 19 comprises a substantially parallelepiped-shaped casing 20 housing a stator 21 and a rotor 22, which has a respective shaft 23 fitted on the bottom end with a respective spindle 14. Each shaft 23 is integral with respective rotor 22 and is supported by two bearings 24a, 24b arranged vertically with respect to each other. Casing 20 of each actuator 19 is of a width A (Figure 2) substantially equal to the spacing B between two adjacent tools 3 of the same drilling device 11 or 12. More specifically, the spacing B between two adjacent tools 3 of the same drilling device 11, 12 is 64 mm in Europe and 60 mm in other countries such as Japan.

Rotor 22 of each actuator 19 of bottom device 12 is located over plate 13, and spindle 14 extends beneath plate through a hole 25 formed through plate 13.

Using an actuator 19 coaxial with each of spindles 14 enables the torque produced by actuator 19 to be transmitted directly to respective tool 3, and is particularly advantageous in the case of heads 1 comprising actuators 19 for operating respective spindles 14 at high speed. As is known, the absence of a mechanical transmission reduces energy dissipation in the form of heat and noise, and spindles 14 can rotate much faster than those of currently marketed heads, by eliminating the transmission components, e.g. gears, belts, etc., between actuator 19 and spindle 14.

As stated, head 1 according to the present invention differs from those of the known state of the art by comprising two similar devices 11, 12 for drilling panels 2 clamped to bed 5; and device 11 is superimposed over device 12, rests on plate 15, and is offset with respect to device 12 underneath.

In the Figure 2 embodiment, each shaft 23 of top device 11 is longer than each shaft 23 of device 12, so that each spindle 14 of device 11 projects from plate 13 and is aligned horizontally with the number of spindles 14 of device 12. In other words, the difference in length between each shaft 23 of device 11 and each shaft 23 of bottom device 12 must be substantially equal to the height of an actuator 19 of device 12 plus the height of plate 13.

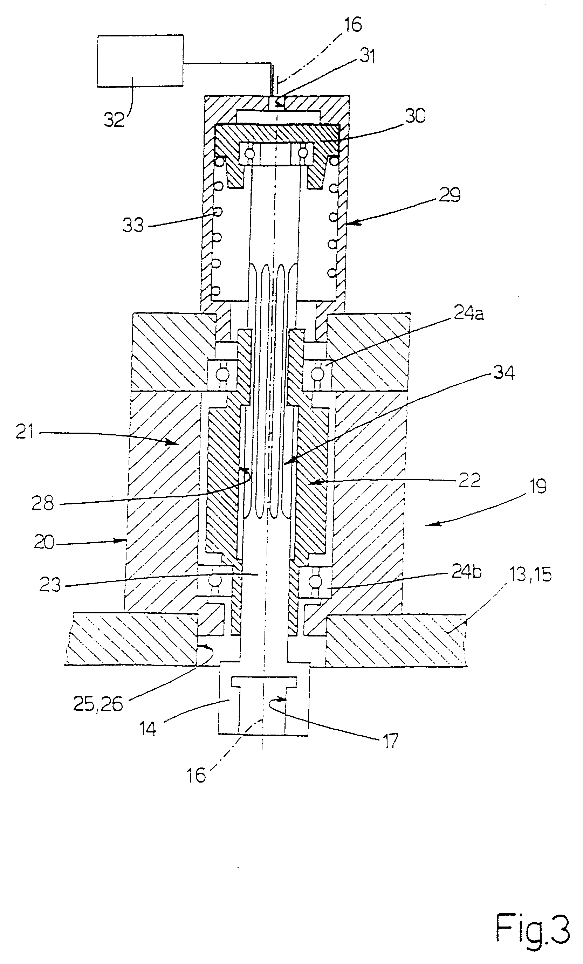

If provision is made, however, for axial displacement of shafts 23 (Figure 3), shafts 23 of both devices 11 and 12 may be the same length.

As such, each shaft 23 of device 11 extends through a respective said hole 25 and a respective hole 26 formed through plate 15.

Offsetting the position of device 11 with respect to device 12 therefore gives a standard 32 mm (30 mm in Japan) center distance C between adjacent tools 3.

In other words, while maintaining a standard center distance C between adjacent tools 3, even though forming part of physically separate devices 11, 12, the solution adopted in the Figure 2 head 1 provides for employing actuators 19 of twice the width A (e.g. 64 mm) of those in the second known embodiment described above. This therefore eliminates the need for excessive miniaturization of the electric components of each actuator, thus extending the working life of the components, increasing the power transmitted by the actuator to the spindle and respective tool, and also increasing the static torque.

Head 1 also comprises a programmable logic controller 27 - only shown in Figure 1 alongside head 1, for the sake of simplicity - for selecting as required the actuators 19 to be activated to perform a given machining cycle.

Operation of head 1 is easily deducible from the foregoing description.

Clearly, changes may be made to head 1 as described and illustrated herein without, however, departing from the scope of the present invention.

Figure 3, for example, shows part of a drilling head 1 in accordance with the invention and featuring independent spindles 14 movable axially and independently with respect to respective axes 16.

With appropriate alterations, the Figure 3 solution may be applied to actuators 19 of both devices 11 and 12.

As shown in Figure 3, to maintain the same design connecting each spindle 14 to a respective actuator 19, head 1 comprises, for each actuator 19, a shaft 23 connected angularly to and disconnected axially from respective rotor 22, which has a through hole 28 along rotation axis 16 and through which shaft 23 extends. Rotor 22 and shaft 23 are so connected as to enable shaft 23 to move vertically between a top rest position and a bottom work position, and rotor 22 obviously always rotates shaft 23. Casing 20 is fitted on top with a box body 29 inside which extends a top portion of shaft 23 fitted with a piston 30, which defines a top chamber connected by a hole 31 to a fluidic device 32, and a bottom chamber housing a preloaded spring 33 for opposing the downward movement of shaft 23. Device 32 obviously provides, by means of controller 27, for feeding pressurized fluid into the top chamber of body 29 to move piston 30 - and hence the assembly defined by shaft 23, spindle 14 and tool 3 (not shown in Figure 3) - downwards in opposition to spring 33. Obviously, displacement of shaft 23 with respect to rotor 22 of actuator 19 is made possible by a splined coupling 34 between rotor 22 and shaft 23.

As will be clear to a person skilled in the art, the choice of the actuating device for moving each independent spindle 14 axially along axis 16 in no way affects the present invention.

When activated, device 32 therefore moves shaft 23 and corresponding tool 3 into the work position, which axial movement may be performed at any time, regardless of whether actuator 19 is moving or stationary, by virtue of coupling 34 between shaft 23 and rotor 22.

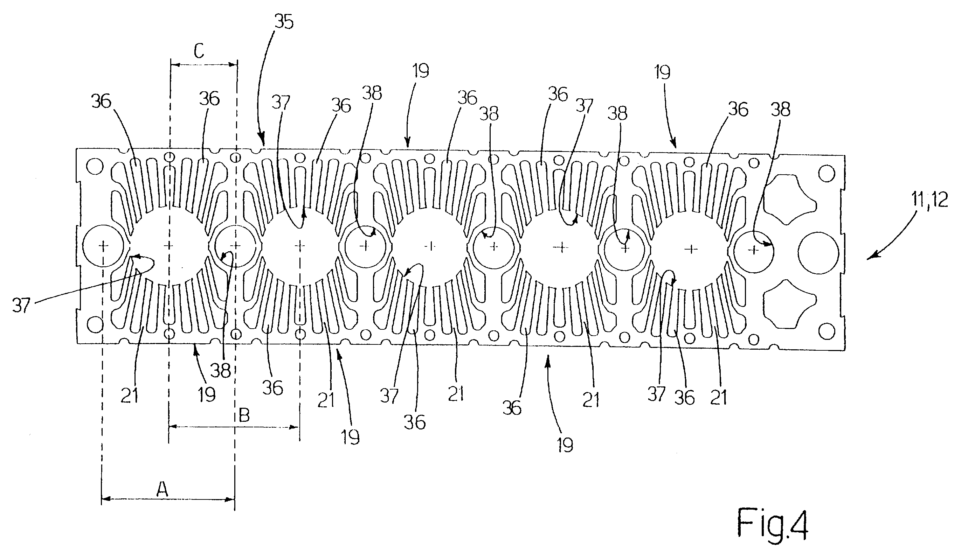

Figure 4 shows a plan view of a variation of a detail of either one of devices 11 and 12.

In this variation, the stator 21 of each actuator 19 of one, and only one, of devices 11, 12 is formed in a one-piece block 35 together with the stators 21 of similar actuators 19 of the same device 11 or 12. Inside block 35 are formed a number of cavities 36 for receiving the windings of conducting material (not shown in Figure 4); and a number of through openings 37, each for receiving a respective rotor 22 (not shown in Figure 4). If used in the construction of device 12, block 35 also comprises a number of holes 38, each for the passage of a respective shaft 23 (not shown in Figure 4) of device 11 above. In this case, too, center distance C is substantially half center distance B.

In the Figure 4 embodiment, the lateral cavities 36 for receiving the windings (not shown in Figure 4) of each stator 21 are deformed to make room for a hole 38. As will be clear to a person skilled in the art, however, this provision is unnecessary if, for example, the width A of each stator 21 is 56 mm, and the diameter of each shaft 23 (not shown in Figure 4), and hence of hole 38 for receiving it, is 8 mm, thus giving the desired center distance C of 32 mm.

## Claims

1. A spindle drilling head (1) for machine tools (4) for machining panels (2) of wood, plastic or other materials of similar hardness; said head (1) comprising a number of side by side spindles (14), each having a respective longitudinal axis (16) of rotation; each said spindle (14) supporting a respective tool (3); an actuator (19), cooperating with each said spindle (14), being provided to rotate the respective said spindle (14); each said actuator (19) being connected mechanically to only one of said spindles (14); and said head (1) being characterized by comprising at least a first (11) and at least a second (12) drilling device superimposed one over the other, each drilling device (11, 12) comprising a respective number of said actuators (19) associated with a respective number of said spindles (14); and in that the spindles (14) in the first number of spindles (14) of said first drilling device (11) are offset with respect to the spindles (14) in the second number of spindles (14) of said second drilling device (12), so that, in general, each axis (16) of each spindle (14) of said first drilling device (11) is located between two adjacent actuators (19) of the second drilling device (12).

2. A head (1) as claimed in Claim 1, wherein the width (A) of each actuator (19) is substantially equal to or less than the center distance (B) between two adjacent axes (16) of two actuators (19) of the same device (11 or 12).

3. A head (1) as claimed in Claim 2, wherein the center distance (C) between two adjacent axes (16) of different devices (11, 12) is substantially half the center distance (B) between two adjacent axes (16) of the same device (11 or 12).

4. A head (1) as claimed in any one of the foregoing Claims, wherein said second device (12) is supported by a first plate (13) having a number of through holes (25), through each of which extends a respective shaft (23) of a respective actuator (19).

5. A head (1) as claimed in Claim 5, wherein said first device (11) is supported by a second plate (15) substantially parallel to the first plate (13); said second plate (15) having a number of through holes (26), through each of which extends a shaft (23) of an actuator (19) of said first device (11).

6. A head (1) as claimed in Claim 6, wherein each through hole (25) in the first plate and each through hole (26) in the second plate are aligned and both fitted through with a shaft (23) of an actuator (19) of said first device (11).

7. A head (1) as claimed in any one of the foregoing Claims, wherein a hole (38) is provided between two adjacent actuators (19) of said second device (12), and is fitted through with a shaft (23) of an actuator (19) of said first device (11).

8. A head (1) as claimed in any one of the foregoing Claims, wherein at least one rotor (22) of at least one actuator (19) is connected to a shaft (23) supported by at least one pair of bearings (24a, 24b).

9. A head (1) as claimed in Claim 8, wherein said rotor (22) has a through hole (28) extending along its axis (16) and fitted through with the shaft (23); a splined coupling (34) being formed between said rotor (22) and said shaft (23) to enable said shaft (23) to move vertically between a top rest position and a bottom work position.

10. A head (1) as claimed in Claim 9, wherein means are also provided for moving said shaft (23) from said rest position to said work position and vice versa; said means comprising a box body (29) carried by the respective said actuator (19) and inside which extends a top portion of said shaft (23), and a piston (30) carried by said shaft (23) and which, inside said body (29), defines a top chamber connected to a fluidic device (32), and a bottom chamber housing a preloaded spring (33) for opposing the downward movement of said shaft (23).

11. A head (1) as claimed in any one of the foregoing Claims, wherein said actuator (19) is a brushless electric motor.

12. A head (1) as claimed in any one of Claims 1 to 10, wherein said actuator (19) is a direct-current electric motor.

13. A head (1) as claimed in any one of Claims 1 to 10, wherein said actuator (19) is an asynchronous electric motor.

14. A head (1) as claimed in any one of the foregoing Claims, wherein the stators (21) of the actuators (19) of one, and only one, device (11 or 12) are formed in a one-piece block (35).

15. A head (1) as claimed in Claim 14, wherein said one-piece block (35) is provided internally with a number of cavities (36) for receiving the windings of conducting material; and a number of through openings (37), each for receiving a respective rotor (22).

16. A head (1) as claimed in Claim 15, wherein the one-piece block (35), when used in the construction of said second device (12), is also provided with a number of holes (38), each for the passage of a respective shaft (23) of said first device (11).
